(19) **Europäisches Patentamt / European Patent Office / Office européen des brevets**

(11) **EP 4 023 716 B1**

(12) **EUROPEAN PATENT SPECIFICATION**

(45) Date of publication and mention
of the grant of the patent:
**10.06.2026 Bulletin 2026/24**

(21) Application number: **20856569.7**

(22) Date of filing: **25.08.2020**

(51) International Patent Classification (IPC):
$C08L\ 33/00$ (2006.01)  $C08F\ 2/44$ (2006.01)
$C08F\ 20/10$ (2006.01)  $C08F\ 265/00$ (2006.01)
$C08F\ 265/06$ (2006.01)  $C08K\ 3/22$ (2006.01)
$C08K\ 5/00$ (2006.01)  $C09K\ 5/14$ (2006.01)
$H01L\ 23/36$ (2006.01)  $H01L\ 23/373$ (2006.01)

(52) Cooperative Patent Classification (CPC):
(C-Sets available)
**H10W 40/251; C08F 2/44; C08F 220/1808;
C08F 265/06; C09D 4/06; C09K 5/14**   (Cont.)

(86) International application number:
**PCT/JP2020/031918**

(87) International publication number:
**WO 2021/039749 (04.03.2021 Gazette 2021/09)**

(54) **TWO-COMPONENT-TYPE RESIN COMPOSITION FOR HEAT-RADIATING MATERIAL**

**ZWEI-KOMPONENTEN-HARZZUSAMMENSETZUNG FÜR WÄRMEABSTRAHLENDES MATERIAL**

**COMPOSITION DE RÉSINE DE TYPE À DEUX COMPOSANTS POUR MATÉRIAU À RAYONNEMENT DE CHALEUR**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.08.2019 JP 2019158363
25.11.2019 JP 2019212506**

(43) Date of publication of application:
**06.07.2022 Bulletin 2022/27**

(73) Proprietor: **Nippon Shokubai Co., Ltd.
Osaka-shi, Osaka 541-0043 (JP)**

(72) Inventors:
• **SAKATA Naoki
Suita-shi, Osaka 564-0034 (JP)**
• **YASUMURA Kazunari
Suita-shi, Osaka 564-0034 (JP)**
• **KAWATA Yuichi
Suita-shi, Osaka 564-0034 (JP)**
• **IMAIZUMI Yohei
Suita-shi, Osaka 564-0034 (JP)**

(74) Representative: **Schön, Christoph
Dr. Schön, Neymeyr & Partner mbB
Bavariaring 26
80336 München (DE)**

(56) References cited:
JP-A- 2004 339 426   JP-A- 2005 048 124
JP-A- 2006 096 982   JP-A- 2006 278 476
JP-A- 2009 179 743   JP-A- 2019 131 734
US-A1- 2002 068 785   US-A1- 2007 142 528

(52) Cooperative Patent Classification (CPC): (Cont.)

C-Sets
**C08F 265/06, C08F 220/1808, C08F 222/102;**
**C09D 4/06, C08F 265/06;**
C08F 220/1808, C08F 220/20

# EP 4 023 716 B1

**Description**

TECHNICAL FIELD

The present invention relates to a two-component-type resin composition for a heat-radiating material. More specifically, the present invention relates to a two-component-type resin composition for a heat-radiating material, which is useful for uses such as a material for releasing heat generated from a heating element such as an electric component or an electronic component used in a battery of an automobile by intervening the material for releasing heat between the heating element and a heat radiator such as a heat sink, a heat radiation fin, a resin film or a metal plate.

BACKGROUND ART

As a resin composition for a heat-radiating material which is excellent not only in thermal conductivity but also in moldability to a heat-radiating sheet and flexibility, a resin composition for a heat-radiating material including a liquid resin containing a (meth)acrylic polymer (A), a polymerizable monomer (B) and a plasticizer (C) as essential components, wherein a hardness of a cured product of the liquid resin is 5 to 70 has been proposed (see, for example, Patent Literature 1).

The resin composition for a heat-radiating material is excellent in thermal conductivity, moldability in molding the resin composition to produce a heat-radiating sheet, and flexibility of the heat-radiating sheet. Accordingly, the resin composition can be suitably used for uses for releasing heat which generates from a heating element by intervening the resin composition between the heating element and a heat-radiating material. The resin composition for a heat-radiating material is cured, for example, by allowing the resin composition in an oven heated to 100°C for about 1 hour (see paragraph [0058] of Patent Literature 1).

US 2007/142528 A1 discloses a curable resin composition comprising a (meth)acrylate monomer, an organic peroxide, a decomposition accelerator for the organic peroxide, and an inorganic filler, wherein the inorganic filler has a particle size distribution such that it has peak diameters at least in the respective regions of from 3 to 10 $\mu$m and from 30 to 70 $\mu$m, and the mode diameter is from 30 to 70 $\mu$m and the median diameter is from 5 to 40 $\mu$m.

However, in recent years, it has been desired to develop a resin composition for a heat-radiating material which can be quickly cured without heating on a production line from the viewpoint of increase in area of the heat-radiating material, efficiency of manufacturing the heat-radiating material, and simplification of processes for producing the heat-radiating material.

PRIOR ART LITERATURES

PATENT LITERATURES

Patent Literature 1: Japanese Patent Unexamined Publication No. 2005-48124

SUMMARY OF THE INVENTION

PROBLEMS TO BE SOLVED BY THE INVENTION

The present invention has been made in view of the above-mentioned prior art, and an object of the present invention is to provide a resin composition for a heat-radiating material that can be quickly cured at room temperature.

MEANS FOR SOLVING THE PROBLEM

The present invention provides a two-component-type resin composition for a heat-radiating material as defined in appended claim 1. Preferred embodiments are defined in the appended dependent claims.

EFFECT OF THE INVENTION

According to the present invention, there is provided a resin composition for a heat-radiating material as defined in appended claim 1 that can be quickly cured at room temperature.

MODE FOR CARRYING OUT THE INVENTION

As described above, the two-component-type resin composition for a heat-radiating material according to the present invention and as defined in appended claim 1 includes a liquid A and a liquid B. The liquid A includes a (meth)acrylic polymer, a radically polymerizable monomer, a reaction accelerator, at least one crosslinking agent selected from the group consisting of a (meth)acrylate-based crosslinking agent and an allyl group-containing crosslinking agent and a thermally conductive material. The liquid B includes a (meth)acrylic polymer and a peroxide-based polymerization initiator.

The two-component-type resin composition for a heat-radiating material according to the present invention includes the liquid A and the liquid B separately. When the liquid A is mixed with the liquid B, the liquid A reacts with the liquid B, and thereby a heat-radiating material is obtained. Therefore, the heat-radiating material is a reaction product of the liquid A and the liquid B.

Incidentally, in the present invention, the term "(meth)acryl" means "acryl" or "methacryl", and the term "(meth) acrylate" means "acrylate" or "methacrylate".

[Liquid A]

The liquid A includes a (meth)acrylic polymer, a radically polymerizable monomer, a reaction accelerator, and a crosslinking agent as described above.

The (meth)acrylic polymer has a structural unit derived from the (meth)acrylic monomer. The structural unit derived from a (meth)acrylic monomer is a unit having a structure in which a carbon-carbon double bond of the (meth) acrylic monomer becomes a carbon-carbon single bond. The structural unit derived from the (meth)acrylic monomer is introduced into the (meth)acrylic polymer by polymerizing the (meth)acrylic monomer.

The (meth)acrylic monomer includes an alkyl (meth)acrylate and a hydroxyl group-containing (meth)acrylate.

The alkyl (meth)acrylate includes, for example, alkyl (meth)acrylates having an alkyl group of 1 to 18 carbon atoms, such as methyl (meth)acrylate, ethyl (meth)acrylate, n-butyl (meth)acrylate, isobutyl (meth)acrylate, tert-butyl (meth)acrylate, sec-butyl (meth)acrylate, 2-ethylhexyl (meth)acrylate, n-octyl (meth)acrylate, tridecyl (meth)acrylate and n-lauryl (meth)acrylate. These alkyl (meth)acrylates can be used alone or in combination of two or more kinds thereof. Among the alkyl (meth)acrylates, the alkyl group having an alkyl group of 1 to 8 carbon atoms is preferable, and n-butyl (meth)acrylate and 2-ethylhexyl (meth)acrylate are more preferable, from the viewpoint of enhancement of flexibility of a heat-radiating material after cured, and improvement of followability of the heat-radiating material to a heat-generating body and a heat-radiating body.

The content of the alkyl (meth)acrylate in the (meth)acrylic monomer is preferably 50 % by mass or more, more preferably 60 % by mass or more, furthermore preferably 70 % by mass or more, and even more preferably 80 % by mass or more, from the viewpoint of enhancement of flexibility of a heat-radiating material after cured, and improvement of followability of the heat-radiating material to a heat-generating body and a heat-radiating body.

The hydroxyl group-containing (meth)acrylate includes, for example, hydroxyl group-containing (meth)acrylates having an ester moiety of 1 to 18 carbon atoms, such as 2-hydroxyethyl (meth)acrylate, 2-hydroxypropyl (meth)acrylate, 3-hydroxypropyl (meth)acrylate, 2-hydroxybutyl (meth)acrylate, 4-hydroxybutyl (meth)acrylate and glycerol mono(meth) acrylate. These hydroxyl group-containing (meth)acrylates can be used alone or in combination of two or more kinds thereof. Among the hydroxyl group-containing (meth)acrylates, 2-hydroxyethyl (meth)acrylate and glycerol mono(meth) acrylate are preferable, and 2-hydroxyethyl (meth)acrylate is more preferable, and 2-hydroxyethyl acrylate is even more preferable, from the viewpoint of quick curing of the resin composition for a heat-radiating material at room temperature. In addition, 2-hydroxyethyl (meth)acrylate and glycerol mono(meth)acrylate are preferable, 2-hydroxyethyl (meth)acrylate is more preferable, and 2-hydroxyethyl acrylate is furthermore preferable, from the viewpoint of improvement in dispersion stability of a thermally conductive material in the liquid A.

The content of the hydroxyl group-containing (meth)acrylate in the (meth)acrylic monomer is 0.3 % by mass or more, preferably 0.5 % by mass or more, and furthermore preferably 1 % by mass or more, from the viewpoint of improvement in dispersion stability of the resin composition for a heat-radiating material and reduction of a viscosity of the resin composition for a heat-radiating material. The content of the hydroxyl group-containing (meth)acrylate in the (meth) acrylic monomer is 30 % by mass or less, preferably 25 % by mass or less, and furthermore preferably 20 % by mass or less, from the viewpoint of reduction of a viscosity of the (meth)acrylic polymer and improvement in compatibility of the (meth)acrylic monomer and the radically polymerizable monomer. Therefore, the content of the hydroxyl group-containing (meth)acrylate in the (meth)acrylic monomer is 0.3 to 30 % by mass, preferably 0.5 to 20 % by mass, and furthermore preferably 1 to 20 % by mass.

Incidentally, the above-mentioned (meth)acrylic monomer may contain, for example, a cycloalkyl (meth)acrylate such as cyclopropyl (meth)acrylate, cyclobutyl (meth)acrylate, cyclopentyl (meth)acrylate, cyclohexyl (meth)acrylate or isobornyl (meth)acrylate, a carbon-carbon double bond-containing monomer having a carboxyl group such as (meth) acrylic acid, a carbon-carbon double bond-containing monomer having a silane group, a carbon-carbon double bond-containing monomer having a nitrogen atom, a carbon-carbon double bond-containing monomer having an oxo group, a carbon-carbon double bond-containing monomer having a fluorine atom, a carbon-carbon double bond-containing monomer having an epoxy group, a carbon-carbon double bond-containing monomer having an aralkyl group, and an aromatic monomer having a carbon-carbon double bond such as styrene, other than the above-mentioned monomers, within a scope which would not hinder an object of the present invention.

The (meth)acrylic polymer can be prepared, for example, by polymerizing the (meth)acrylic monomer with a polymerization method such as a bulk polymerization method, a solution polymerization method or an emulsion polymerization method. Among these polymerization methods, the bulk polymerization method is preferable from the viewpoint of avoidance of inclusion of a solvent or a dispersing medium into the (meth)acrylic polymer.

The glass transition temperature of the (meth)acrylic polymer is preferably -20 °C or lower, and more preferably -30 °C or lower, from the viewpoint of enhancement of flexibility of a heat-radiating material after cured, and improvement of followability of the heat-radiating material to a heat-generating body and a heat-radiating body. The lower limit of the glass transition temperature of the (meth)acrylic polymer is preferably -200 °C or higher, and more preferably -180 °C or higher.

In the present invention, the glass transition temperature of a polymer means a temperature as determined by using a glass transition temperature of a homopolymer of a monomer which is used as a raw material of the polymer, and determining a temperature based on the Fox Equation represented by the equation:

$$1/Tg = \Sigma(Wm/Tgm)/100$$

wherein Wm is a content (% by mass) of a "monomer m" in the monomer components which constitute the polymer, and Tgm is a glass transition temperature (absolute temperature: K) of a homopolymer of the "monomer m".

The glass transition temperature of a polymer (non-volatile component) can be determined from a glass transition temperature (Tg) (absolute temperature: K) of a homopolymer made of a monomer which is included in monomer components used as raw materials of the polymer, and a mass fraction of the monomer, on the basis of the Fox Equation represented by the formula (I):

$$1/Tg = W_1/Tg_1 + W_2/Tg_2 + W_3/Tg_3 + \ldots + W_n/Tg_n \qquad (I)$$

wherein Tg is a glass transition temperature (K); each of $W_1$, $W_2$, $W_3$....$W_n$ is a mass fraction of each monomer; each of $Tg_1$, $Tg_2$, $Tg_3$....$Tg_n$ is a glass transition temperature (K) of a homopolymer made of a monomer corresponding to the mass fraction of each monomer.

The glass transition temperature of a polymer described herein means a glass transition temperature as determined based on the formula (I). Incidentally, when a monomer having an unknown glass transition temperature is used, the glass transition temperature of a polymer is determined by using only the monomers having a known glass transition temperature.

The composition of the radically polymerizable monomer used as a raw material of the polymer can be determined in consideration of the glass transition temperature of the polymer.

The glass transition temperature of a homopolymer is, for example, 105 °C for a homopolymer of methyl methacrylate; 8 °C for a homopolymer of methyl acrylate; -20 °C for a homopolymer of ethyl acrylate; -56 °C for a homopolymer of n-butyl acrylate; 20 °C for a homopolymer of n-butyl methacrylate; -80 °C for a homopolymer of n-octyl acrylate; -58 °C for a homopolymer of isooctyl acrylate; -70 °C for a homopolymer of 2-ethylhexyl acrylate; 16 °C for a homopolymer of cyclohexyl acrylate; 83 °C for a homopolymer of cyclohexyl methacrylate; -15 °C for a homopolymer of 2-hydroxyethyl acrylate; 55 °C for a homopolymer of 2-hydroxyethyl methacrylate; -40 °C for a homopolymer of 4-hydroxybutyl acrylate; 106 °C for a homopolymer of acrylic acid; 105 °C for a homopolymer of methacrylic acid; 80 °C for a homopolymer of styrene; and a homopolymer of N-vinylpyrrolidone is 170 °C.

The glass transition temperature of the (meth)acrylic polymer means a temperature as determined based on the above method for determining the glass transition temperature of the polymer.

The glass transition temperature of the (meth)acrylic polymer can be easily controlled by appropriately adjusting a kind and an amount of the (meth)acrylic monomer which is used as a raw material of the (meth)acrylic polymer.

The weight average molecular weight of the (meth)acrylic polymer is preferably 50000 or more, and more preferably 100000 or more, from the viewpoint of quick curing of the resin composition for a heat-radiating material at room temperature. The weight average molecular weight of the (meth)acrylic polymer is preferably 1500000 or less, and more preferably 1000000 or less, from the viewpoint of quick curing of the resin composition for a heat-radiating material at room temperature. Therefore, the weight average molecular weight of the (meth)acrylic polymer is preferably 50000 to 1500000, and more preferably 100000 to 1500000.

Incidentally, the weight average molecular weight of the (meth)acrylic polymer described herein is a converted value based on polystyrene standard as determined by using a measurement device of gel permeation chromatography manufactured by Tosoh Co., Ltd. under a product number of HLC-8220 GPC, and a separation column manufactured by Tosoh Co., Ltd. under a product name of TSKgel Super HZM-M.

The total amount of the (meth)acrylic polymer which is used in the liquid A and the liquid B described later per 100 parts by mass of the radically polymerizable monomer used in the liquid A is preferably 30 parts by mass or more, and more preferably 35 parts by mass or more, from the viewpoint of quick curing of the resin composition for a heat-radiating material at room temperature, and is preferably 90 parts by mass or less, more preferably 85 parts by mass or less, and furthermore preferably 80 parts by mass or less, from the viewpoint of quick curing of the resin composition for a heat-radiating material at room temperature. Therefore, the total amount of the (meth)acrylic polymer which is used in the liquid A and the liquid B described later per 100 parts by mass of the radically polymerizable monomer used in the liquid A is preferably 30 to 90 parts by mass, more preferably 35 to 85 parts by mass, and furthermore preferably 35 to 80 parts by mass.

The radically polymerizable monomer includes, for example, an alkyl (meth)acrylate, a cycloalkyl (meth)acrylate, a hydroxyl group-containing (meth)acrylate, an aromatic monomer having a carbon-carbon double bond, a carboxyl group-containing monomer having a carbon-carbon double bond, a nitrogen atom-containing monomer having a carbon-carbon double bond, an oxo group-containing monomer having a carbon-carbon double bond, a fluorine atom-containing monomer having a carbon-carbon double bond, and an epoxy group-containing monomer having a carbon-carbon double bond. These monomers can be used alone or in combination of two or more kinds thereof.

Among the radically polymerizable monomers, the alkyl (meth)acrylate, the cycloalkyl (meth)acrylate, the hydroxyl group-containing (meth)acrylate, the aromatic monomer having a carbon-carbon double bond and the carboxyl group-containing monomer having a carbon-carbon double bond are preferable; the alkyl (meth)acrylate, the cycloalkyl (meth)acrylate, the hydroxyl group-containing (meth)acrylate and the carboxyl group-containing monomer having a carbon-carbon double bond are more preferable; the alkyl (meth)acrylate, the cycloalkyl (meth)acrylate and the hydroxyl group-containing (meth)acrylate are furthermore preferable; and the alkyl (meth)acrylate still furthermore preferable, from the viewpoint of quick curing of the resin composition for a heat-radiating material at room temperature.

The alkyl (meth)acrylate includes, for example, alkyl (meth)acrylates having an alkyl group of 1 to 18 carbon atoms, such as methyl (meth)acrylate, ethyl (meth)acrylate, n-butyl (meth)acrylate, isobutyl (meth)acrylate, tert-butyl (meth)acrylate, sec-butyl (meth)acrylate, 2-ethylhexyl (meth)acrylate, n-octyl (meth)acrylate, tridecyl (meth)acrylate and n-lauryl (meth)acrylate. These alkyl (meth)acrylates can be used alone or in combination of two or more kinds thereof. Among the alkyl (meth)acrylates, the alkyl (meth)acrylate having an alkyl group of 1 to 8 carbon atoms is preferable, and n-butyl (meth)acrylate and 2-ethylhexyl (meth)acrylate are more preferable, from the viewpoint of enhancement of flexibility of a heat-radiating material after cured, and improvement of followability of the heat-radiating material to a heat-generating body and a heat-radiating body.

The content of the alkyl (meth)acrylate in the radically polymerizable monomer is preferably 50 % by mass or more, more preferably 60 % by mass or more, furthermore preferably 70 % by mass or more, and even more preferably 80 % by mass or more, from the viewpoint of enhancement of flexibility of a heat-radiating material after cured, and improvement of followability of the heat-radiating material to a heat-generating body and a heat-radiating body. The upper limit of the content of the alkyl (meth)acrylate in the radically polymerizable monomer is 100 % by mass. Therefore, the content of the alkyl (meth)acrylate in the radically polymerizable monomer is preferably 50 to 100 % by mass, more preferably 60 to 100 % by mass, furthermore preferably 70 to 100 % by mass, and even more preferably 80 to 100 % by mass.

The cycloalkyl (meth)acrylate includes, for example, cyclopropyl (meth)acrylate, cyclobutyl (meth)acrylate, cyclopentyl (meth)acrylate, cyclohexyl (meth)acrylate, and isobornyl (meth)acrylate. These cycloalkyl (meth)acrylates can be used alone or in combination of two or more kinds thereof. Among the cycloalkyl (meth)acrylates, the cycloalkyl (meth)acrylate having a cycloalkyl group of 3 to 12 carbon atoms is preferable, the cycloalkyl (meth)acrylate having a cycloalkyl group of 3 to 10 carbon atoms is more preferable, the cycloalkyl (meth)acrylate having a cycloalkyl group of 4 to 8 carbon atoms is furthermore preferable, and cyclohexyl (meth)acrylate is even more preferred, from the viewpoint of quick curing of the resin composition for a heat-radiating material at room temperature.

The content of cycloalkyl (meth)acrylate in the radically polymerizable monomer is 0 % by mass or more, preferably 0.5 % by mass or more, more preferably 1 % by mass or more, furthermore preferably 2 % by mass or more, and even more preferably 3 % by mass or more, from the viewpoint of improvement in toughness of the heat-radiating material after cured. The content of cycloalkyl (meth)acrylate in the radically polymerizable monomer is preferably 50 % by mass or less, more preferably 40 % by mass or less, furthermore preferably 30 % by mass or less, and even more preferably 20 % by mass or less, from the viewpoint of enhancement of flexibility of a heat-radiating material after cured, and improvement of followability of the heat-radiating material to a heat-generating body and a heat-radiating body. Therefore, the content of the cycloalkyl (meth)acrylate in the radically polymerizable monomer is preferably 0.5 to 50 % by mass, more preferably 1 to 40 % by mass, furthermore preferably 2 to 30 % by mass, and even more preferably 3 to 20 % by mass.

The hydroxyl group-containing (meth)acrylate includes, for example, hydroxyl group-containing (meth)acrylates having an ester moiety of 1 to 18 carbon atoms, such as 2-hydroxyethyl (meth)acrylate, 2-hydroxypropyl (meth)acrylate, 3-hydroxypropyl (meth)acrylate, 2-hydroxybutyl (meth)acrylate, 4-hydroxybutyl (meth)acrylate and glycerol mono(meth)acrylate. These hydroxyl group-containing (meth)acrylates can be used alone or in combination of two or more kinds thereof. Among the hydroxyl group-containing (meth)acrylates, 2-hydroxyethyl (meth)acrylate and glycerol mono(meth)acrylate are preferable, 2-hydroxyethyl (meth)acrylate is more preferable, and 2-hydroxyethyl acrylate is furthermore preferable, from the viewpoint of quick curing of the resin composition for a heat-radiating material at room temperature.

The content of the hydroxyl group-containing (meth)acrylate in the radically polymerizable monomer is 0 % by mass or more, preferably 0.1 % by mass or more, more preferably 0.3 % by mass or more, and furthermore preferably 0.5 % by mass or more, from the viewpoint of improvement in dispersion stability of the resin composition for a heat-radiating material and reduction of a viscosity of the resin composition for a heat-radiating material. The content of the hydroxyl group-containing (meth)acrylate is preferably 10 % by mass or less, more preferably 5 % by mass or less, and furthermore preferably 3 % by mass or less, from the viewpoint of improvement in dispersibility of components other than the thermally conductive material. Therefore, the content of the hydroxyl group-containing (meth)acrylate in the radical polymerizable monomer is preferably 0.1 to 10 % by mass, more preferably 0.3 to 5 % by mass, and furthermore preferably 0.5 to 5 % by mass.

The aromatic monomer having a carbon-carbon double bond includes, for example, styrene, $\alpha$-methylstyrene, p-methylstyrene, tert-methylstyrene, chlorostyrene, aralkyl (meth)acrylate, and vinyltoluene. The aralkyl (meth)acrylate includes, for example, aralkyl (meth)acrylates having an aralkyl group of 7 to 18 carbon atoms, such as benzyl (meth) acrylate, phenylethyl (meth)acrylate, methylbenzyl (meth)acrylate and naphthylmethyl (meth)acrylate. These aromatic monomers can be used alone or in combination of two or more kinds thereof. Among the aromatic monomers, styrene is preferable from the viewpoint of quick curing of the resin composition for a heat-radiating material at room temperature.

The content of the aromatic monomer having a carbon-carbon double bond in the radically polymerizable monomer is 0 % by mass or more, preferably 1 % by mass or more, more preferably 2 % by mass or more, and furthermore preferably 3 % by mass or more, from the viewpoint of improvement in toughness of the heat-radiating material after cured. The content of the aromatic monomer having a carbon-carbon double bond in the radically polymerizable monomer is preferably 10 % by mass or less, and more preferably 8 % by mass or less, from the viewpoint of quick curing of the resin composition for a heat-radiating material at room temperature. Therefore, the content of the aromatic monomer in the radically polymerizable monomer is preferably 0 to 10 % by mass, more preferably 1 to 10 % by mass, furthermore preferably 2 to 8 % by mass, and even more preferably 3 to 8 % by mass.

The carboxyl group-containing monomer having a carbon-carbon double bond includes, for example, a carboxyl group-containing aliphatic monomer having a carbon-carbon double bond and an acid anhydride group-containing aliphatic monomer having a carbon-carbon double bond, such as (meth)acrylic acid, maleic acid, fumaric acid, crotonic acid, itaconic acid and maleic anhydride. These carboxyl group-containing monomers having a carbon-carbon double bond can be used alone or in combination of two or more kinds thereof. Among the carboxyl group-containing monomers having a carbon-carbon double bond, (meth)acrylic acid is preferable from the viewpoint of quick curing of the resin composition for a heat-radiating material at room temperature.

The content of the carboxyl group-containing monomer having a carbon-carbon double bond in the radically polymerizable monomer is 0 % by mass or more, preferably 0.1 % by mass or more, more preferably 0.2 % by mass or more, and furthermore preferably 0.3 % by mass or more, from the viewpoint of improvement in toughness of the heat-radiating material after cured. The content of the carboxyl group-containing monomer having a carbon-carbon double bond in the radically polymerizable monomer is preferably 5 % by mass or less, more preferably 3 % by mass or less, and furthermore preferably 2 % by mass or less, from the viewpoint of quick curing of the resin composition for a heat-radiating material at room temperature. Therefore, the content of the carboxyl group-containing monomer having a carbon-carbon double bond in the radically polymerizable monomer is preferably 0 to 5 % by mass, more preferably 0.1 to 5 % by mass, furthermore preferably 0.2 to 3 % by mass, and even more preferably 0.3 to 2 % by mass.

The nitrogen atom-containing monomer having a carbon-carbon double bond includes, for example, (meth) acrylamide compounds such as (meth)acrylamide, diacetone (meth)acrylamide, N-monomethyl (meth)acrylamide, N-monoethyl (meth)acrylamide, N,N-dimethyl (meth)acrylamide, N-n-propyl (meth)acrylamide, N-isopropyl (meth)acrylamide, methylene bis(meth)acrylamide, N-methylol (meth)acrylamide, N-butoxymethyl (meth)acrylamide, dimethylaminoethyl (meth)acrylamide, N, N-dimethylaminopropyl (meth)acrylamide, and diacetone (meth)acrylamide; dimethylaminoethyl (meth)acrylate, diethylaminoethyl (meth)acrylate, N-vinyl pyrrolidone, and (meth)acrylonitrile. These nitrogen atom-containing monomers can be used alone or in combination of two or more kinds thereof.

The oxo group-containing monomer having a carbon-carbon double bond includes, for example, (di)ethylene glycol (methoxy)(meth)acrylates such as 2-methoxyethyl (meth)acrylate, 2-ethoxyethyl (meth)acrylate, 2-propoxyethyl (meth)acrylate, 2-butoxyethyl (meth)acrylate, 3-methoxypropyl (meth)acrylate, 3-ethoxypropyl (meth)acrylate, 4-methoxybutyl (meth)acrylate, 4-ethoxybutyl (meth)acrylate, 2-methoxytriethylene glycol (meth)acrylate, ethylene glycol (meth) acrylate, ethylene glycol methoxy(meth)acrylate, diethylene glycol (meth)acrylate and diethylene glycol methoxy(meth) acrylate. These oxo group-containing monomers can be used alone or in combination of two or more kinds thereof.

The fluorine atom-containing monomer having a carbon-carbon double bond includes, for example, fluoroalkyl (meth)acrylates having a fluoroalkyl group of 2 to 6 carbon atoms, such as trifluoroethyl (meth)acrylate, tetrafluoropropyl (meth)acrylate and octafluoropentyl (meth)acrylate. The fluorine atom-containing monomers having a carbon-carbon double bond can be used alone or in combination of two or more kinds thereof.

The epoxy group-containing monomer having a carbon-carbon double bond includes, for example, an epoxy group-containing (meth)acrylate such as glycidyl (meth)acrylate. The epoxy group-containing monomers having a carbon-carbon double bond can be used alone or in combination of two or more kinds thereof.

The glass transition temperature of a polymer prepared by polymerizing the radical-polymerizable monomer is preferably -20° C or less, and more preferably -30 °C or less, from the viewpoint of enhancement of flexibility of a heat-radiating material after cured, and improvement of followability of the heat-radiating material to a heat-generating body and a heat-radiating body. Incidentally, the lower limit of the glass transition temperature of the polymer is preferably -180 °C or more, and more preferably -160 °C or more.

The reaction accelerator has a property that the reaction accelerator accelerates decomposition of the peroxide-based polymerization initiator included in the liquid B, and generation of an active radical from the peroxide-based polymerization initiator, when the liquid A is mixed with the liquid B.

The reaction accelerator includes, for example, imidazole, 2-methylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-aminomethyl-2-methylimidazole, 1-(2-cyanoethyl)-2-phenylimidazole, aniline, N,N-dimethylaniline, N,N-diethylaniline, m-toluidine, p-toluidine, N-ethyl-m-toluidine, N,N-dimethyl-p-toluidine, N,N-bis(2-hydroxyethyl)-p-toluidine, N,N-bis(2-hydroxypropyl)-p-toluidine, p-tolyldiethanolamine, N-phenyl-N'-ethylethanolamine, N-phenyldiethanolamine, triethanolamine, diethylenetriamine, 4-(N,N-dimethylamino)benzaldehyde, 4-[N,N-bis(2-hydroxyethyl)amino]benzaldehyde, 4-(N-methyl-N-hydroxyethylamino)benzaldehyde, pyridine, piperidine, phenylimorpholine, N,N-bis(hydroxy)ethyl)aniline, diethanolaniline, ethylenethiourea, diethylthiourea, tetramethylthiourea, N-acetylthiourea, N-benzoylthiourea, diphenylthiourea, dicyclohexylthiourea, copper naphthenate, barium naphthenate, cobalt naphthenate, zinc octylate, vanadium octylate, and cobalt octylate. These reaction promoters can be used alone or in combination of two or more kinds thereof.

Among the reaction accelerators, a reaction accelerator having an alkanolamine skeleton is preferable, a reaction accelerator having an ethanolamine skeleton is more preferable, a reaction accelerator having a diethanolamine skeleton such as p-tolyldiethanolamine or N-phenyldiethanolamine is furthermore preferable, from the viewpoint of quick curing of the resin composition for a heat-radiating material at room temperature.

The amount of the reaction accelerator per 100 parts by mass of the radical polymerizable monomer is preferably 0.01 to 10 parts by mass, and more preferably 0.05 to 5 parts by mass, from the viewpoint of acceleration of an effect and quick curing of the resin composition for a heat-radiation material at room temperature.

As the crosslinking agent, at least one crosslinking agent selected from the group consisting of a (meth)acrylate-based crosslinking agent and an allyl group-containing crosslinking agent is used. The (meth)acrylate-based crosslinking agent and the allyl group-containing crosslinking agent can be used alone or in combination thereof.

The (meth)acrylate-based crosslinking agent includes, for example, (poly)ethylene glycol di(meth)acrylates such as tetraethylene glycol di(meth)acrylate; (poly)propylene glycol di(meth)acrylate, neopentyl glycol di(meth)acrylate, 1,9-nonandiol di(meth)acrylate, 1,6-hexanediol di(meth)acrylate, 1,4-butanediol di(meth)acrylate, trimethylolpropane di(meth)acrylate, trimethylolpropane tri(meth)acrylate, pentaerythritol tri(meth)acrylate, pentaerythritol tetra(meth)acrylate, dipentaerythritol hexa(meth)acrylate, ethoxylated pentaerythritol tetra(meth)acrylate, dipentaerythritol penta(meth)acrylate, and urethane (meth)acrylate. These (meth)acrylate-based crosslinking agents can be used alone or in combination of two or more kinds thereof.

The allyl-group containing crosslinking agent includes, for example, a polyfunctional allyl ester, and a polyfunctional allyl ether. These allyl group-containing crosslinking agents can be used alone or in combination of two or more kinds thereof. The allyl group-containing crosslinking agent has advantageous merits such that a mechanical strength of a cured heat-radiating material formed from the resin composition for the heat-radiating material can be increased, even in an area which is not covered with a masking film when the resin composition for a heat-radiating material is cured.

The polyfunctional allyl ester is an allyl ester having two or more allyl groups in its molecule. The polyfunctional allyl ester includes, for example, allyl group-containing cyanurate compounds such as triallyl isocyanurate and triallyl cyanurate; an aliphatic polyfunctional allyl ester represented by the formula (II):

$$X\text{-}[COOCH_2CH=CH_2]_n \qquad (II)$$

wherein X is an n-valent aliphatic hydrocarbon group, and n is a valent number of the aliphatic hydrocarbon group. These polyfunctional allyl esters can be used alone or in combination of two or more kinds thereof.

The aliphatic polyfunctional allyl ester represented by the formula (II) includes, for example, diallyl oxalate, diallyl malonate, diallyl succinate, diallyl glutarate, diallyl adipate, diallyl pimelate, diallyl suberate, diallyl azelate, diallyl sebacate, diallyl fumarate, diallyl maleate, triallyl citrate, diallyl tartrate, diallyl itaconate, and diallyl citraconate.

The polyfunctional allyl ether is an allyl ether having two or more allyl groups in its molecule. The polyfunctional allyl ether includes, for example, glycerol diallyl ether, glycerol triallyl ether, 1,4-butanediol diallyl ether, nonanediol diallyl ether, 1,4-cyclohexanedimethanol diallyl ether, triethylene glycol diallyl ether, trimethylolpropane diallyl ether, trimethylolpropane triallyl ether, ditrimethylolpropane tetraallyl ether, pentaerythritol diallyl ether, pentaerythritol triallyl ether, pentaerythritol tetraallyl ether, dipentaerythritol pentaallyl ether, dipentaerythritol hexaallyl ether, sorbitol diallyl ether, 1,3-bis(allyloxy)adamantane, 1,3,5-tris(allyloxy)adamantane, bisphenol S diallyl ether, bisphenol A diallyl ether, bisphenol A alkylene oxide diallyl ether, bisphenol F alkylene oxide diallyl ether, 2,5-diallyl phenol allyl ether, novolak phenol allyl ether, allylated polyphenylene oxide, a compound in which a glycidyl group of an epoxy resin is replaced with an allyl group, 1,1,2,2-tetraallyloxyetane, ethylene glycol diallyl ether, diethylene glycol diallyl ether, polyethylene glycol diallyl ether, propylene glycol diallyl ether, butylene glycol diallyl ether, and hexanediol diallyl ether.

Among the crosslinking agents, the allyl group-containing crosslinking agent is preferable, and the allyl group-containing cyanurate compound is more preferable, from the viewpoint of enhancement of flexibility of a heat-radiating material after cured, and improvement of followability of the heat-radiating material to a heat-generating body and a heat-radiating body as well as increase in mechanical strength of a cured product of the heat-radiating material obtained from the resin composition for a heat-radiating material; and triallyl isocyanurate and triallyl cyanurate are furthermore preferable, and triallyl cyanurate is even more preferable, from the viewpoint of increase in curability.

In addition, when the (meth)acrylate-based crosslinking agent is used together with the allyl group-containing crosslinking agent, flexibility of the heat-radiating material after cured can be enhanced, followability of the heat-radiating material to a heat-generating body and a heat-radiating body can be improved, and also mechanical strength of a cured product of the heat-radiating material obtained from the resin composition for a heat-radiating material can be increased, as synergistic effects exhibited by a combined use of the (meth)acrylate-based crosslinking agent and the allyl group-containing crosslinking agent. When the (meth)acrylate-based crosslinking agent is used together with the allyl group-containing crosslinking agent, a mass ratio of the allyl group-containing crosslinking agent to the (meth)acrylate-based crosslinking agent [allyl group-containing crosslinking agent / (meth)acrylate-based crosslinking agent] is preferably 1.5/1 to 5/1, and more preferably 2/1 to 5/1, from the viewpoint of enhancement of flexibility of the heat-radiating material after cured, and improvement in followability of the heat-radiating material to a heat-generating body and a heat-radiating body, as synergistic effects exhibited by a combined use of the (meth)acrylate-based crosslinking agent and the allyl group-containing crosslinking agent.

Incidentally, the crosslinking agent may contain a diene-based crosslinking agent such as 1,5-hexadiene, 1,9-decadiene, 1,3-diisopropenylbenzene or 1,4-diisopropenylbenzene within a scope which would not hinder an object of the present invention.

The amount of the crosslinking agent per 100 parts by mass of the radically polymerizable monomer is preferably 0.001 part by mass or more, and more preferably 0.05 part by mass or more, from the viewpoint of quick curing of the resin composition for a heat-radiating material at room temperature, and is preferably 10 parts by mass or less, and more preferably 5 parts by mass or less, from the viewpoint of ensuring of a toughness of a cured heat-radiating material. Therefore, the amount of the crosslinking agent per 100 parts by mass of the radically polymerizable monomer is preferably 0.001 to 10 parts by mass, and more preferably 0.05 to 5 parts by mass.

It is preferred that a plasticizer is included in the liquid A from the viewpoint of quick curing of the resin composition for a heat-radiating material at room temperature.

The plasticizer includes, for example, trimellitic acid ester-based plasticizers such as tris(2-ethylhexyl) trimellitate, tris(n-octyl) trimellitate and tris(isononyl) trimellitate; phthalic acid ester-based plasticizers such as dimethyl phthalate, diethyl phthalate, dibutyl phthalate, dihexyl phthalate, dioctyl phthalate, diisononyl phthalate, di-2-ethylhexyl phthalate, dibenzyl phthalate, diisodecyl phthalate, ditridecyl phthalate and diundecyl phthalate; adipic acid ester-based plasticizers such as di-n-butyl adipate, diisobutyl adipate, dibutoxyethyl adipate, di-n-octyl adipate, diisooctyl adipate, diisononyl adipate, bis(2-ethylhexyl) adipate and diisodecyl adipate; phosphoric acid ester-based plasticizers such as tributyl phosphate, tris(2-ethylhexyl) phosphate, trioctyl phosphate, triphenyl phosphate, diphenyl-2-ethylhexyl phosphate and tricresyl phosphate; sebacic acid ester-based plasticizers such as dibutyl sebacate, dioctyl sebacate and di-2-ethylhexyl sebacate; azelaic acid ester-based plasticizers such as dihexyl azelate and dioctyl azelate; citric acid ester-based plasticizers such as triethyl citrate, acetyltriethyl citrate and tri-n-butyl citrate; glycolic acid ester-based plasticizers such as methylphthalylethyl glycolate and ethylphthalylethyl glycolate; trimellitic acid ester-based plasticizers such as trioctyl trimellitate, tri-n-octyl-n-decyl trimellitate and trialkyl trimellitate having an alkyl group of 4 to 11 carbon atoms; ricinoleic acid ester-based plasticizers such as methyl acetyl ricinoleate, butyl acetyl ricinoleate and glycerol monoricinoleate; maleic acid ester-based plasticizers such as di-n-butyl malate; itaconic acid ester-based plasticizers such as monobutyl itaconate; oleic acid ester-based plasticizers such as butyl oleate; glycerol-based plasticizers such as glycerol monoaceto monolaurate, glycerol diaceto monolaurate, glycerol monoaceto monostearate and glycerol diaceto monoolate. These plasticizers can be used alone or in combination of two or more kinds thereof. Among the plasticizers, the trimellitic acid ester-based plasticizer is preferable from the viewpoint of avoidance of vaporization of the plasticizer and improvement in thermal stability of the plasticizer over a long period of time.

The amount of the plasticizer per 100 parts by mass of the total amount of the (meth)acrylic polymer used in the liquid A and the liquid B is preferably 50 to 700 parts by mass, more preferably 80 to 600 parts by mass, and furthermore preferably 100 to 500 parts by mass, from the viewpoint of enhancement of flexibility of the heat-radiating material after cured, and improvement in followability of the heat-radiating material to a heat-generating body and a heat-radiating body.

The liquid A contains a thermally conductive material from the viewpoint of improvement in thermal conductivity of the heat-radiating material. The thermally conductive material includes, for example, carbonate particles, such as alkali metal carbonate particles such as sodium carbonate particles, sodium hydrogen carbonate particles, potassium carbonate particles and potassium hydrogen carbonate particles, alkaline earth metal carbonate particles such as magnesium carbonate particles, calcium carbonate particles and barium carbonate particles, ammonium carbonate particles such as ammonium carbonate particles and ammonium hydrogen carbonate particles; zinc oxide particles, aluminum oxide particles, magnesium oxide particles, beryllium oxide particles, calcium oxide particles, zirconium oxide particles, aluminum oxide (alumina) particles, titanium dioxide particles, silica particles, magnesium hydroxide particles, aluminum hydroxide particles, calcium silicate particles, aluminum silicate particles, silicon carbide particles, silicon nitride particles, boron nitride particles, calcium sulfate particles, barium sulfate particles, magnesium carbonate particles, glass particles, kaolin, talc, mica powder, metal particles, and carbon black particles. These thermally conductive materials can be used alone or in combination of two or more kinds thereof. Among the thermally conductive materials, the aluminum oxide (alumina) particles are preferable from the viewpoint of improvement in thermal conductivity of a heat-radiating material obtained by using the two-component-type resin composition for a heat-radiating material according to the present invention.

The average particle diameter of the thermally conductive material is preferably 0.3 $\mu$m or more, more preferably 0.5 $\mu$m or more, and furthermore preferably 1 $\mu$m or more, from the viewpoint of avoidance of aggregation of the thermally conductive material, and is preferably 100 $\mu$m or less, more preferably 80 $\mu$m or less, and furthermore preferably 50 $\mu$m or less, from the viewpoint of improvement in dispersion stability of the thermally conductive material. Therefore, the average particle diameter of the thermally conductive material is preferably 0.3 to 100 $\mu$m, more preferably 0.5 to 80 $\mu$m, and furthermore preferably 1 to 50 $\mu$m. Incidentally, the average particle diameter of the thermally conductive material means a volume average particle diameter as determined by using a particle size analyzer [manufactured by Beckmann Coulter Inc., product number: LS 13320], which is based on a laser diffraction scattering method.

The amount of the thermally conductive material per 100 parts by mass of the total amount of the (meth)acrylic polymer and the radically polymerizable monomer is preferably 400 parts by mass or more, more preferably 500 parts by mass or more, and furthermore preferably 600 parts by mass or more, from the viewpoint of improvement in thermal conductivity of a heat-radiating material obtained by using the two-component-type resin composition for a heat-radiating material, and is preferably 1800 parts by mass or less, more preferably 1600 parts by mass or less, furthermore preferably 1400 parts by mass or less, and even more preferably 1200 parts by mass or less, from the viewpoint of reduction of viscosity of the two-component-type resin composition for a heat-radiating material and improvement in strength of the heat-radiating material after curing is reduced. Therefore, the amount of the thermally conductive material per 100 parts by mass of the total amount of the (meth)acrylic polymer and the radically polymerizable monomer is preferably 400 to 1800 parts by mass, more preferably 500 to 1600 parts by mass, furthermore preferably 600 to 1400 parts by mass, and even more preferably 600 to 1200 parts by mass.

The liquid A can be easily prepared by blending a composition containing the (meth)acrylic polymer, the radically polymerizable monomer, the reaction accelerator, the (meth)acrylate-based crosslinking agent, the thermally conductive material and as occasion demands, the plasticizer, by using a means such as a batch mixer, a tumbler, a Henschel mixer, a Banbury mixer, a roll, a kneader, a single-screw extruder or a twin-screw extruder. The temperature at which the composition is blended, can be room temperature, a temperature higher than room temperature, or a temperature lower than room temperature. In addition, the atmosphere where the composition is blended, can be the air. However, the atmosphere can be, for example, an inert gas such as nitrogen gas or argon gas, from the viewpoint of avoidance of influence caused by oxygen gas included in the air.

[Liquid B]

The liquid B contains the (meth)acrylic polymer and the peroxide-based polymerization initiator as described above.

The (meth)acrylic polymer can be the same as the (meth)acrylic polymer which is used in the liquid A.

The total amount of the (meth)acrylic polymers used in the liquid A and the liquid B per 100 parts by mass of the radically polymerizable monomer used in the liquid A is preferably 30 parts by mass or more, and more preferably 35 parts by mass or more, from the viewpoint of quick curing of the resin composition for a heat-radiating material at room temperature as mentioned above, and is preferably 90 parts by mass or less, and more preferably 85 parts by mass or less, and furthermore preferably 80 parts by mass or less, from the viewpoint of quick curing of the resin composition for a heat-radiating material at room temperature. Therefore, the total amount of the (meth)acrylic polymer used in the liquid A and the liquid B per 100 parts by mass of the radically polymerizable monomer used in the liquid A is preferably 30 to 90 parts by mass, more preferably 35 to 85 parts by mass, and furthermore preferably 35 to 80 parts by mass.

The peroxide-based polymerization initiator includes, for example, a ketone peroxide-based polymerization initiator, a hydroperoxide-based polymerization initiator and a diacyl peroxide-based polymerization initiator, each of which has been used as a redox-based catalyst. These polymerization initiators can be used alone or in combination of two or more kinds thereof.

The ketone peroxide-based polymerization initiator includes, for example, methyl ethyl ketone peroxide, cyclohexanone peroxide, methylcyclohexanone peroxide, methylaceto acetate peroxide, and acetylacetone peroxide. These polymerization initiators can be used alone or in combination of two or more kinds thereof.

The hydroperoxide-based polymerization initiator includes, for example, p-menthane hydroperoxide, diisopropylbenzene hydroperoxide, 1,1,3,3-tetramethylbutylhydroperoxide, cumene hydroperoxide, tert-hexyl hydroperoxide, and tert-butyl hydroperoxide. These polymerization initiators can be used alone or in combination of two or more kinds thereof.

The diacyl peroxide-based polymerization initiator includes, for example, isobutyl peroxide, 3,5,5-trimethylhexanoyl peroxide, octanoyl peroxide, lauroyl peroxide, stearoyl peroxide, succinic acid peroxide, m-toluoyl peroxide, m-benzoyl peroxide, and benzoyl peroxide. These polymerization initiators can be used alone or in combination of two or more kinds thereof.

The amount of the peroxide-based polymerization initiator per 100 parts by mass of the radically polymerizable monomer used in the liquid A is preferably 0.05 parts by mass or more, and more preferably 0.1 parts by mass or more, from the viewpoint of quick curing of the resin composition for a heat-radiating material at room temperature, and is preferably 5 parts by mass or less, and more preferably 3 parts by mass or less, from the viewpoint of prolongation of a pot life of the resin composition for a heat-radiating material, and increase in flexibility of the heat-radiating material after cured. Therefore, the amount of the peroxide-based polymerization initiator per 100 parts by mass of the radically polymerizable monomer used in the liquid A is preferably 0.05 to 5 parts by mass, and more preferably 0.1 to 3 parts by mass.

The mass ratio of the reaction accelerator to the peroxide-based polymerization initiator (reaction accelerator / peroxide-based polymerization initiator) is preferably 30/70 to 90/10, more preferably 50/50 to 85/15, and furthermore preferably 60/40 to 80/20, from the viewpoint of quick curing of the resin composition for a heat-radiating material at room temperature. In addition, the mass ratio of the reaction accelerator to the peroxide-based polymerization initiator (reaction accelerator / peroxide-based polymerization initiator) is preferably 30/70 to 90/10, more preferably 35/65 to 85/15, and furthermore preferably 40/60 to 80/20, from the viewpoint of quickly curing the resin composition for a heat-radiating material while maintaining a temporal stability of the resin composition for a heat-radiating material.

The preferred combination of the reaction accelerator and the peroxide-based polymerization initiator is a combination of the reaction accelerator having an alkanolamine skeleton and the benzoyl peroxide-based polymerization initiator from the viewpoint of quick curing of the resin composition for a heat-radiating material at room temperature.

It is preferred that the liquid B contains a plasticizer from the viewpoint of quick curing of the resin composition for a heat-radiating material at room temperature. The plasticizer can be the same as the plasticizer which is used in the liquid A.

The amount of the plasticizer per 100 parts by mass of the total amount of the (meth)acrylic polymer used in the liquid A and the liquid B is preferably 50 to 700 parts by mass, more preferably 80 to 600 parts by mass, and furthermore preferably 100 to 500 parts by mass, from the viewpoint of enhancement of flexibility of the heat-radiating material after cured, and improvement in followability of the heat-radiating material to a heat-generating body and a heat-radiating body.

It is preferred that a polyfunctional thiol compound is included in at least one member selected from the group consisting of the liquid A and the liquid B from the viewpoint of increase in mechanical strength of a cured product of the heat-radiating material obtained from the resin composition for a heat-radiating material. It is more preferred that the polyfunctional thiol compound is included in the liquid B from the viewpoint of enhancement of storage stability of the thiol compound in the liquid.

The polyfunctional thiol compound is a compound which has two or more mercapto groups in its molecule. Among the polyfunctional thiol compounds, a polyfunctional thiol compound having 2 to 6 mercapto groups is preferable from the viewpoint of enhancement of flexibility of the heat-radiating material after cured, and improvement in followability of the heat-radiating material to a heat-generating body and a heat-radiating body, as well as increase in mechanical strength of a cured product of the heat-radiating material obtained from the resin composition for a heat-radiating material.

The molecular weight of the polyfunctional thiol compound is preferably 100 to 2000, and more preferably 200 to 1000, from the viewpoint of enhancement of flexibility of the heat-radiating material after cured, and improvement in followability of the heat-radiating material to a heat-generating body and a heat-radiating body, as well as increase in mechanical strength of a cured product of the heat-radiating material obtained from the resin composition for a heat-radiating material.

Among the polyfunctional thiol compounds, a polyfunctional thiol compound that is liquid at room temperature (25°C) is preferable from the viewpoint of handle ability. The polyfunctional thiol compound can be a primary thiol, a secondary thiol, or a mixture of the primary thiol and the secondary thiol.

The polyfunctional thiol compound includes, for example, hexanedithiol, decandithiol, 1,4-butanediol bisthioglycolate, ethylene glycol bisthioglycolate, 1,3,5-tris(3-mercaptopropionyloxyethyl)isocyanurate, 1,3,5-tris(3-mercaptobutylyloxyethyl)isocyanurate, trimethylolpropanetris(3-mercaptopropionate), pentaerythritol tetrakisthioglycolate, pentaerythritol tetrakis(3-mercaptopropionate), pentaerythritol tetrakis(3-mercaptobutyrate), tris[(3-mercaptopropionyloxy) ethyl] isocyanurate, trimethylolpropane tris(3-mercaptopropionate), tetraethylene glycol bis(3-mercaptopropionate), dipentaerythritol hexakis(3-mercaptopropionate), 1,4-dimethylmercaptobenzene, 2,4,6-trimercapto-s-triazine, 2-(N,N-dibutylamino)-4,6-dimercapto-s-triazine, 1,3-bis(mercaptomethyl)glycoluril, 1,3-bis(2-mercaptoethyl)glycoluril, 1,3-bis(3-mercaptopropyl)glycoluril, 1,3-bis(4-mercaptobutyl)glycoluril, 1,4-bis(mercaptomethyl)glycoluril, 1,4-bis(2-mercaptoethyl)glycoluril, 1,4-bis(3-mercaptopropyl)glycoluril, 1,4-bis(4-mercaptobutyl)glycoluril, 1,6-bis(mercaptomethyl) glycoluril, 1,6-bis(2-mercaptoethyl)glycoluril, 1,6-bis(3-mercaptopropyl)glycoluril, 1,6-bis(4-mercaptobutyl)glycoluril, tris(mercaptomethyl)glycoluril, tris(2-mercaptoethyl)glycoluril, tris(3-mercaptopropyl)glycoluril, tris(4-mercaptobutyl)glycoluril, tetrakis(mercaptomethyl)glycoluril, tetrakis(2-mercaptoethyl)glycoluril, tetrakis(3-mercaptopropyl)glycoluril, and tetrakis(4-mercaptobutyl)glycoluril. These polyfunctional thiol compounds can be used alone or in combination of two or more kinds thereof.

The amount of the polyfunctional thiol compound per 100 parts by mass of the total amount of the (meth)acrylic polymer used in the liquid A and the liquid B is preferably 0.5 to 20 parts by mass, more preferably 1 to 10 parts by mass, and furthermore preferably 2 to 5 parts by mass, from the viewpoint of enhancement of flexibility of the heat-radiating material after cured, and improvement in followability of the heat-radiating material to a heat-generating body and a heat-radiating body, as well as increase in mechanical strength of a cured product of the heat-radiating material obtained from the resin composition for a heat-radiating material.

Incidentally, the liquid B may contain a thermally conductive material within a scope which would not hinder an object the present invention. The thermally conductive material can be the same as the plasticizer which is used in the liquid A.

The liquid B can be easily prepared by blending a composition containing the (meth)acrylic polymer and the peroxide-based polymerization initiator, as occasion demands, the polyfunctional thiol compound, and the plasticizer, by using a means such as a batch mixer, a tumbler, a Henschel mixer, a Banbury mixer, a roll, a kneader, a single-screw extruder or a twin-screw extruder. The temperature at which the composition is blended, can be room temperature, a temperature higher than room temperature, or a temperature lower than room temperature. In addition, the atmosphere where the composition is blended, can be the air. However, the atmosphere can be, for example, an inert gas such as nitrogen gas or argon gas, from the viewpoint of avoidance of influence caused by oxygen gas included in the air.

The liquid A and the liquid B may contain an additive, respectively within a scope which would not hinder an object of the present invention. The additive includes, for example, a coloring agent such as a pigment, a leveling agent, an ultraviolet absorber, an ultraviolet stabilizer, an antioxidant, a polymerization inhibitor, a filler, a coupling agent, a rust preventive, an antibacterial agent, a metal inactivation agent, a wetting agent, a defoaming agent, a surfactant, a reinforcing agent, a plasticizer, a lubricant, an antifogging agent, an anticorrosive agent, a pigment dispersant, a flow modifier, a peroxide-decomposing agent, a mold bleach, an optical brighter, an organic flame retardant, an inorganic flame retardant, a drip inhibitor, a melt flow modifier, an antistatic agent, an algae inhibitor, an antifungal agent, a flame retardant, a slip agent, a metal chelating agent, an anti-blocking agent, a thermally stabilizing agent, a processing stabilizer, a dispersant, a thickener, a rheology control agent, a foaming agent, an anti-aging agent, a preservative, an antistatic agent, a silane coupling agent, an antioxidant, and a film-forming aid. These additives can be used alone or in combination of two or more kinds thereof.

[Two-component-type resin composition for a heat-radiating material]

The two-component-type resin composition for a heat-radiating material according to the present invention has the liquid A and the liquid B obtained in the above.

As mentioned above, the amount of the (meth)acrylic polymer used in the liquid B is adjusted so that a ratio of the amount of the (meth)acrylic polymer used in the liquid B to the radically polymerizable monomer used in the liquid A becomes a predetermined ratio. The amount of peroxide-based polymerization initiator used in the liquid B is adjusted so that a ratio of the amount of the peroxide-based polymerization initiator to the radically polymerizable monomer used in the liquid A becomes a predetermined ratio. The amount of the plasticizer used in the liquid B is adjusted so that a ratio of the amount of the plasticizer to a total amount of the radically polymerizable monomer used in the liquid A and the (meth)acrylic polymer used in the liquid B becomes a predetermined ratio.

In addition, it is preferred that the amount of the liquid A from which the amount of the thermally conductive material is excluded is 3 to 300 parts by mass or so per 100 parts by mass of the liquid B in consideration of convenience in mixing the liquid A with the liquid B.

According to the present invention, when the liquid A is mixed with the liquid B, there is no necessity to heat the resulting mixture as in the conventional case to produce a heat-radiating material, because the liquid A is reacted with the liquid B quickly even at room temperature, so that the heat-radiating material can be efficiently produced, for example, on a production line in a factory.

When the liquid A is mixed with the liquid B, a stirring device can be used. The stirring device includes, for example, a batch mixer, a tumbler, a Henschel mixer, a Banbury mixer, a roll, a kneader, a single-screw extruder, and a twin-screw extruder. The temperature at which the liquid A is mixed with the liquid B is preferably room temperature from the viewpoint of efficient production of the heat-radiating material without using a device such as a heating device or a cooling device. The room temperature cannot be absolutely determined, because the room temperature varies depending on a region on the earth. However, the room temperature is usually 0 to 40 °C, preferably 0 to 35 °C, and more preferably 1 to 30 °C. In addition, a temperature at which the liquid A is mixed with the liquid B, can be a temperature higher than room temperature or a temperature lower than room temperature as occasion demands. It is preferred that the temperature at which the liquid A is mixed with the liquid B, is 0 to 50 °C or so from the viewpoint of efficient production of the heat-radiating material. In addition, the atmosphere where the liquid A is mixed with the liquid B, can be the air. However, the atmosphere can be, for example, an inert gas such as nitrogen gas or argon gas, from the viewpoint of avoidance of influence caused by oxygen gas included in the air.

When the liquid A is mixed with the liquid B, curing of the resulting mixture is initiated. The curing of the mixture usually ends for 30 to 90 minutes or so from the start of mixing at room temperature. The end point of curing of the mixture can be regarded as a tack-free time on the surface of a heat-radiating material obtained from the mixture. The tack-free time means a period of time from a time at which the liquid A is mixed with the liquid B to a time at which human fingers from which oils and fats have been removed with ethanol are not sticked to a surface of a heat-radiating material which is formed by curing the mixture of the liquid A and the liquid B.

As mentioned above, the liquid A and the liquid B included in the two-component-type resin composition for a heat-radiating material according to the present invention are mixed together, to react the liquid A with the liquid B, and thereby a heat-radiating material is obtained.

The shape of the heat-radiating material includes, for example, a sheet shape (a film shape), a tape shape, a cylindrical shape, and a shape of a desired molded body. The heat-radiating material having a sheet shape or a tape shape can be produced by, for example, a method which includes mixing the liquid A with the liquid B, coating the resulting mixture on a substrate by means of a brush, a bar coater, an applicator, an air spray, an airless spray, a roll coater, or a flow coater, to form a film, and curing the formed film; a method which includes mixing the liquid A with the liquid B, extruding the resulting mixture from an extrusion molding machine through a T-die to form a sheet or a film, and curing the sheet or the film. A heat-radiating material having a cylindrical shape can be produced by, for example, a method which includes mixing the liquid A with the liquid B, extruding the resulting mixture from an extrusion molding machine through a spider to form a cylindrical heat-radiating material, and curing the cylindrical heat-radiating material. A molded body having a desired shape can be produced by, for example, a method which includes mixing the liquid A with the liquid B, molding the resulting the mixture to a desired shape by means of an injection molding machine.

A thermal conductivity of the heat-radiating material can be controlled, for example, by adjusting an amount of the thermally conductive material. The thermal conductivity of the heat-radiating material is preferably 0.5 W/m· K or more, and more preferably 1 W/m·K or more, from the viewpoint of enhancement of the heat radiation performance of the heat-radiating material. Incidentally, the thermal conductivity of the heat-radiating material is a value as determined at a temperature of 25 °C by using a quick thermal-conductivity meter manufactured by KYOTO ELECTRONICS MANUFACTURING CO., LTD. under the product number of QTM-500.

EXAMPLES

Next, the present invention is more specifically described based on working examples.

Example 1

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 95/5, weight average molecular weight: 250000, glass transition temperature: about -68 °C] as a (meth)acrylic polymer, 7.1 g of a trimellitic acid ester-based plasticizer, 9.8 g of 2-ethylhexyl acrylate, 0.39 g of N,N-bis(2-hydroxyethyl)-p-toluidine as a reaction accelerator, and 0.27 g of 1,6-hexanediol diacrylate [manufactured by KYOEISYA CHEMICAL CO., LTD., product name: LIGHT ACRYLATE 1.6 HX-A] as a (meth)acrylate-based crosslinking agent at room temperature (about 25 °C) in the air so as to be uniformly dispersed. Thereafter, 172.0 g of alumina powder (average particle diameter: 10 $\mu$m) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 95/5, weight average molecular weight: 250000, glass transition temperature: about -68 °C] as a (meth)acrylic polymer, 5.4 g of a trimellitic acid ester-based plasticizer, and 0.56 g of benzoyl peroxide [manufactured by NOF CORPORATION, product name: NYPER NS] as a peroxide-based polymerization at room temperature (about 25 °C) in the air so as to be uniformly dispersed.

Next, a two-component-type resin composition for a heat-radiating material having the liquid A and the liquid B was prepared, and the following physical properties of two-component-type resin composition for a heat-radiating material were examined. The results are shown in Table 1.

[Pot life]

A period of time from a time at which the liquid A was mixed with the liquid B at 25°C in the air to a time at which a viscosity of the resulting mixture of the liquid A and the liquid B was increased by agitating the mixture with a stirring rod made of glass was measured, and a pot life was evaluated in accordance with the following evaluation criteria.

(Evaluation criteria)

◎: Pot life exceeds 3 minutes.
○: Pot life exceeds 1 minute and less than 3 minutes.
×: Pot life is within 1 minute.

[Curability]

A period of time (tack-free time) was determined by measuring a period of time from a time at which the liquid A was mixed with the liquid B at 25 °C in the air to a time at which human fingers from which oils and fats have been removed with ethanol were not sticked to a surface of a heat-radiating material which was formed by curing the mixture of the liquid A and the liquid B, and a curability was evaluated in accordance with the following evaluation criteria.

(Evaluation criteria)

◎: Tack-free time is within 60 minutes.
○: Tack-free time exceeds 60 minutes and less than 90 minutes.
×: Tack-free time exceeds 90 minutes.

[Thermal conductivity]

The liquid A was mixed with the liquid B at 25 °C in the air, to give a mixture, and the resulting mixture was applied to a polyester film having a smooth surface with a bar coater so as to form a film having a thickness of 3 mm. The film was cured to give a film-shaped heat-radiating material. A thermal conductivity of the heat-radiating material was determined by means of a quick thermal-conductivity meter manufactured by KYOTO ELECTRONICS MANUFACTURING CO., LTD. under the product number of QTM -500. The thermal conductivity was evaluated in accordance with the following evaluation criteria.

(Evaluation criteria)

◎: Thermal conductivity is 1.5 W/m·K or more.
○: Thermal conductivity is 1 W/m·K or more and less than 1.5 W/m·K.
×: Thermal conductivity is less than 1 W/m·K.

[Moldability]

The surface condition of the film-shaped heat-radiating material obtained when the thermal conductivity was examined was observed with naked eyes, and a moldability was evaluated in accordance with the following evaluation criteria.

(Evaluation criteria)

◎: No defect such as unevenness is observed on the surface of a film-shaped heat-radiating material.
×: A defect such as unevenness is observed on the surface of a film-shaped heat-radiating material.

Example 2

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 9.8 g of 2-ethylhexyl acrylate, 0.20 g of N,N-bis(2-hydroxyethyl)-p-toluidine as a reaction accelerator, and 0.27 g of 1,6-hexanediol diacrylate [manufactured by KYOEISYA CHEMICAL CO., LTD., product name: LIGHT ACRYLATE 1.6 HX-A] as a (meth)acrylate-based crosslinking agent at room temperature (about 25 °C) in the air so as to be uniformly dispersed. Thereafter, 172.0 g of alumina powder (average particle diameter: 10 μm) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, and 1.12 g of benzoyl peroxide [manufactured by NOF CORPORATION, product name: NYPER NS] as a peroxide-based polymerization at room temperature (about 25 °C) in the air so as to be uniformly dispersed.
Next, a two-component-type resin composition for a heat-radiating material having the liquid A and the liquid B obtained in the above was prepared, and the physical properties of two-component-type resin composition for a heat-radiating material were examined in the same manner as in Example 1. The results are shown in Table 1.

[Table 1]

| Example No. | Physical properties of two-component-type resin composition for heat-radiating material | | | |
|---|---|---|---|---|
| | Pot life | Curability | Thermal conductivity | Moldability |
| Example 1 | ◎ | ◎ | ◎ | ◎ |
| Example 2 | ◎ | ◎ | ◎ | ◎ |

From the results shown in Table 1, it can be seen that according to each of the working examples, a two-component-type resin composition for a heat-radiating material having a long pot life, and being excellent in curability, thermal conductivity and moldability can be obtained.

Example 3

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 0.39 g of N,N-bis(2-hydroxyethyl)-p-toluidine as a reaction accelerator, 10.1 g of 2-ethylhexyl acrylate, and 0.06 g of 1,6-hexanediol diacrylate [manufactured by KYOEISYA CHEMICAL CO., LTD., product name: LIGHT ACRYLATE 1.6 HX-A] and 0.24 g of triallyl isocyanurate as a crosslinking agent at room temperature (about 25 °C) in the air so as to be uniformly dispersed. Thereafter, 172.0 g of alumina powder (average particle diameter: 10 μm) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, 0.21 g of benzoyl peroxide [manufactured by NOF CORPORATION, product name: NYPER NS] as a peroxide-based polymerization, and 0.1 g of tetrakis(3-mercaptopropyl)glycoluril at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material (cured product) obtained from the two-component-type resin composition for a heat-radiating material was examined in accordance with the following method for evaluating the bending property. The results are shown in Table 2.

[Bending property of heat-radiating material]

A rectangular silicon sheet having a length of 140 mm, a width of 190 mm and a thickness of 3 mm was used, and a through hole having a length of 100 mm and a width of 150 mm was provided in the center of the silicon sheet. A polyester (polyethylene terephthalate) film was bonded to the bottom surface of the silicone sheet to seal, and thereby a forming mold was produced.

The liquid A was mixed with the solution B in the air at room temperature, to give a mixture. The mixture in an amount of about 140 g was poured into a concave part of the forming mold within 10 minutes from the initiation of mixing the liquid A with the liquid B, and the mixture flowed from the mold was removed therefrom. A polyester (polyethylene terephthalate) film having a length of 100 mm and a width of 75 mm was placed on a half area of the surface of the mixture within 3 minutes after the completion of pouring the mixture into the forming mold, to cover a half area of the surface of the mixture with the polyester film.

After the forming mold was allowed to stand for 24 hours in the air at room temperature, the polyester film was removed from the forming mold, a formed heat-radiating material sheet having a thickness of about 3 mm was taken out from the forming mold.

An area of the heat-radiating material sheet covered with the polyester film and an area of the heat-radiating material sheet not covered with the polyester film (exposed area) were bent at an angle of 180°, respectively, and each of the heat-radiating material sheets was held for one second. Thereafter, each of the heat-radiating material sheet was restored to its original shape, and the appearance of the heat-radiating material sheets was observed with naked eyes. The bending property of the heat-radiating material sheet was evaluated in accordance with the following evaluation criteria.

(Evaluation criteria)

◎: No abnormality is observed before and after bending the heat-radiating material sheet.
○: No abnormality is observed before bending of the heat-radiating material sheet. However, after bending of the heat-radiating material sheet, a crack is observed on the surface of heat-radiating material sheet although no peeling is observed on the surface of the heat-radiating material sheet.
□: No abnormality is observed before bending the heat-radiating material sheet. However, after bending of the heat-radiating material sheet, a crack and a peeling are observed on the surface of heat-radiating material sheet after bending.
△: A crack is observed on the surface of heat-radiating material sheet before bending the heat-radiating material sheet.
✕: A crack penetrating the heat-radiating material sheet from a front surface to a rear surface, and breakage of the heat-radiating material sheet are observed, before the heat-radiating material sheet is bent.

Example 4

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 0.39 g of N,N-bis(2-hydroxyethyl)-p-toluidine as a reaction accelerator, 10.1 g of 2-ethylhexyl acrylate, and 0.06 g of 1,6-hexanediol diacrylate [manufactured by KYOEISYA CHEMICAL CO., LTD., product name: LIGHT ACRYLATE 1.6 HX-A] and 0.24 g of triallyl isocyanurate as a crosslinking agent at room temperature (about 25 °C) in the air so as to be uniformly dispersed. Thereafter, 172.0 g of alumina powder (average particle diameter: 10 μm) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, and 0.21 g of benzoyl peroxide [manufactured by NOF CORPORATION, product name: NYPER NS] as a peroxide-based polymerization at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 5

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 0.39 g of N,N-bis(2-hydroxyethyl)-p-toluidine as a reaction accelerator, 10.1 g of 2-ethylhexyl acrylate, and 0.06 g of 1,6-hexanediol diacrylate [manufactured by KYOEISYA CHEMICAL CO., LTD., product name: LIGHT ACRYLATE 1.6 HX-A] and 0.24 g of triallyl cyanurate as a crosslinking agent at room temperature (about 25 °C) in the air so as to be uniformly dispersed. Thereafter, 172.0 g of alumina powder (average particle diameter: 10 μm) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, and 0.21 g of benzoyl peroxide [manufactured by NOF CORPORATION, product name: NYPER NS] as a peroxide-based polymerization at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 6

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 0.39 g of N,N-bis(2-hydroxyethyl)-p-toluidine as a reaction accelerator, 10.1 g of 2-ethylhexyl acrylate, and 0.3 g of triallyl cyanurate as a crosslinking agent at room temperature (about 25 °C) in the air so as to be uniformly dispersed. Thereafter, 172.0 g of alumina powder (average particle diameter: 10 $\mu$m) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, and 0.21 g of benzoyl peroxide [manufactured by NOF CORPORATION, product name: NYPER NS] as a peroxide-based polymerization at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 7

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 0.39 g of N,N-bis(2-hydroxyethyl)-p-toluidine as a reaction accelerator, 10.1 g of 2-ethylhexyl acrylate, and 0.25 g of polyethylene glycol dimethacrylate [manufactured by NOF CORPORATION, product name: BLEMMER PDE-400] as a (meth)acrylate-based crosslinking agent at room temperature (about 25 °C) in the air so as to be uniformly dispersed. Thereafter, 172.0 g of alumina powder (average particle diameter: 10 $\mu$m) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, and 0.21 g of benzoyl peroxide [manufactured by NOF CORPORATION, product name: NYPER NS] as a peroxide-based polymerization at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 8

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 0.39 g of N,N-bis(2-hydroxyethyl)-p-toluidine as a reaction accelerator, 9.8 g of 2-ethylhexyl acrylate, and 0.1 g of 1,6-hexanediol diacrylate [manufactured by KYOEISYA CHEMICAL CO., LTD., product name: LIGHT ACRYLATE 1.6 HX-A] as a crosslinking agent at room temperature (about 25 °C) in the air so as to be uniformly dispersed. Thereafter, 172.0 g of alumina powder (average particle diameter: 10 μm) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, and 0.21 g of benzoyl peroxide [manufactured by NOF CORPORATION, product name: NYPER NS] as a peroxide-based polymerization at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 9

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 0.39 g of N,N-bis(2-hydroxyethyl)-p-toluidine as a reaction accelerator, 10.1 g of 2-ethylhexyl acrylate, and 0.125 g of 1,6-hexanediol diacrylate [manufactured by KYOEISYA CHEMICAL CO., LTD., product name: LIGHT ACRYLATE 1.6 HX-A] and 0.125 g of triallyl isocyanurate as a crosslinking agent at room temperature (about 25 °C) in the air so as to be uniformly dispersed. Thereafter, 172.0 g of alumina powder (average particle diameter: 10 μm) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, and 0.32 g of benzoyl peroxide [manufactured by NOF CORPORATION, product name: NYPER NS] as a peroxide-based polymerization at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 10

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 0.39 g of N,N-bis(2-hydroxyethyl)-p-toluidine as a reaction accelerator, 10.1 g of 2-ethylhexyl acrylate, and 0.10 g of 1,6-hexanediol diacrylate [manufactured by KYOEISYA CHEMICAL CO., LTD., product name: LIGHT ACRYLATE 1.6 HX-A] and 0.20 g of triallyl isocyanurate as a crosslinking agent at room temperature (about 25 °C) in the air so as to be uniformly dispersed. Thereafter, 172.0 g of alumina powder (average particle diameter: 10 μm) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, 0.1 g of pentaerythritol tetrakisthioglycolate as a polyfunctional thiol compound, and 0.21 g of benzoyl peroxide [manufactured by NOF CORPORATION, product name: NYPER NS] as a peroxide-based polymerization at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 11

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 0.39 g of N,N-bis(2-hydroxyethyl)-p-toluidine as a reaction accelerator, 10.1 g of 2-ethylhexyl acrylate, and 0.015 g of 1,6-hexanediol diacrylate [manufactured by KYOEISYA CHEMICAL CO., LTD., product name: LIGHT ACRYLATE 1.6 HX-A] and 0.285 g of triallyl isocyanurate as a crosslinking agent at room temperature (about 25 °C) in the air so as to be uniformly dispersed. Thereafter, 172.0 g of alumina powder (average particle diameter: 10 $\mu$m) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, 0.21 g of benzoyl peroxide [manufactured by NOF CORPORATION, product name: NYPER NS] as a peroxide-based polymerization, and 0.1 g of tetrakis(3-mercaptopropyl)glycoluril as a polyfunctional thiol compound at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 12

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 0.39 g of N,N-bis(2-hydroxyethyl)-p-toluidine as a reaction accelerator, 10.1 g of 2-ethylhexyl acrylate, and 0.03 g of 1,6-hexanediol diacrylate [manufactured by KYOEISYA CHEMICAL CO., LTD., product name: LIGHT ACRYLATE 1.6 HX-A] and 0.27 g of triallyl isocyanurate as a crosslinking agent at room temperature (about 25 °C) in the air so as to be uniformly dispersed. Thereafter, 172.0 g of alumina powder (average particle diameter: 10 $\mu$m) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, 0.21 g of benzoyl peroxide [manufactured by NOF CORPORATION, product name: NYPER NS] as a peroxide-based polymerization, and 0.1 g of tetrakis(3-mercaptopropyl)glycoluril as a polyfunctional thiol compound at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 13

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 0.39 g of N,N-bis(2-hydroxyethyl)-p-toluidine as a reaction accelerator, 10.1 g of 2-ethylhexyl acrylate, and 0.1 g of 1,6-hexanediol diacrylate [manufactured by KYOEISYA CHEMICAL CO., LTD., product name: LIGHT ACRYLATE 1.6 HX-A] as a crosslinking agent at room temperature (about 25 °C) in the air so as to be uniformly dispersed. Thereafter, 172.0 g of alumina powder (average particle diameter: 10 $\mu$m) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, 0.21 g of benzoyl peroxide [manufactured by NOF CORPORATION, product name: NYPER NS] as a peroxide-based polymerization, and 0.1 g of tetrakis(3-mercaptopropyl)glycoluril as a polyfunctional thiol compound at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 14

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, 0.39 g of N,N-bis(2-hydroxyethyl)-p-toluidine as a reaction accelerator, 10.1 g of 2-ethylhexyl acrylate, and 0.06 g of 1,6-hexanediol diacrylate [manufactured by KYOEISYA CHEMICAL CO., LTD., product name: LIGHT ACRYLATE 1.6 HX-A] and 0.24 g of triallyl isocyanurate as a crosslinking agent at room temperature (about 25 °C) in the air so as to be uniformly dispersed. Thereafter, 172.0 g of alumina powder (average particle diameter: 10 $\mu$m) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, 0.21 g of benzoyl peroxide [manufactured by NOF CORPORATION, product name: NYPER NS] as a peroxide-based polymerization, and 0.1 g of pentaerythritol tetrakis(3-mercaptobutylate) as a polyfunctional thiol compound at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 15

[Preparation of a liquid A]

A liquid A was prepared by mixing 4.0 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 6.0 g of a trimellitic acid ester-based plasticizer, 0.39 g of N,N-bis(2-hydroxyethyl)-p-toluidine as a reaction accelerator, 9.8 g of 2-ethylhexyl acrylate, 0.5 g of n-butyl methacrylate, and a mixture of 0.20 g of triacryl isocyanurate and 0.05 g of triallyl isocyanurate and 0.012 g of methoquinone (hydroquinone monomethyl ether) as a crosslinking agent at room temperature (about 25 °C) in the air so as to be uniformly dispersed. Thereafter, 172.0 g of alumina powder (average particle diameter: 10 μm) was added to the liquid A, and these components were blended so as to be uniformly dispersed, to give a mixture. The resulting mixture was used as a liquid A.

[Preparation of liquid B]

A liquid B was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 4.2 g of a trimellitic acid ester-based plasticizer, 0.20 g of benzoyl peroxide [manufactured by NOF CORPORATION, product name: NYPER BW] as a peroxide-based polymerization, and 0.1 g of pentaerythritol tetrakis(3-mercaptobutylate) as a polyfunctional thiol compound at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 16

[Preparation of a liquid A]

A liquid A was prepared by mixing 4.0 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 6.0 g of a trimellitic acid ester-based plasticizer, 0.39 g of N,N-bis(2-hydroxyethyl)-p-toluidine as a reaction accelerator, 9.8 g of 2-ethylhexyl acrylate, 0.5 g of n-butyl methacrylate, and a mixture of 0.05 g of triacryl isocyanurate and 0.20 g of triallyl isocyanurate as a crosslinking agent at room temperature (about 25 °C) in the air so as to be uniformly dispersed. Thereafter, 172.0 g of alumina powder (average particle diameter: 10 μm) was added to the liquid A, and these components were blended so as to be uniformly dispersed, to give a mixture. The resulting mixture was used as a liquid A.

[Preparation of liquid B]

A liquid B was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 4.2 g of a trimellitic acid ester-based plasticizer, 0.20 g of benzoyl peroxide [manufactured by NOF CORPORATION, product name: NYPER BW] as a peroxide-based polymerization, and 0.1 g of pentaerythritol tetrakis(3-mercaptobutylate) as a polyfunctional thiol compound at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 17

[Preparation of a liquid A]

A liquid A was prepared by mixing 4.0 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 6.0 g of a trimellitic acid ester-based plasticizer, 0.39 g of N,N-bis(2-hydroxyethyl)-p-toluidine as a reaction accelerator, 9.8 g of 2-ethylhexyl acrylate, 0.5 g of n-butyl methacrylate, and a mixture of 0.25 g of triacryl isocyanurate and 0.05 g of triallyl isocyanurate and 0.012 g of methoquinone (hydroquinone monomethyl ether) as a crosslinking agent at room temperature (about 25 °C) in the air so as to be uniformly dispersed. Thereafter, 172.0 g of alumina powder (average particle diameter: 10 μm) was added to the liquid A, and these components were blended so as to be uniformly dispersed, to give a mixture. The resulting mixture was used as a liquid A.

[Preparation of liquid B]

A liquid B was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 4.2 g of a trimellitic acid ester-based plasticizer, 0.20 g of benzoyl peroxide [manufactured by NOF CORPORATION, product name: NYPER BW] as a peroxide-based polymerization, and 0.15 g of pentaerythritol tetrakis(3-mercaptobutylate) as a polyfunctional thiol compound at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 18

[Preparation of a liquid A]

A liquid A was prepared by mixing 4.0 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 6.0 g of a trimellitic acid ester-based plasticizer, 0.39 g of N,N-bis(2-hydroxyethyl)-p-toluidine as a reaction accelerator, 9.8 g of 2-ethylhexyl acrylate, 0.5 g of n-butyl methacrylate, and a mixture of 0.25 g of triacryl isocyanurate and 0.05 g of triallyl isocyanurate and 0.015 g of methoquinone (hydroquinone monomethyl ether) as a crosslinking agent at room temperature (about 25 °C) in the air so as to be uniformly dispersed. Thereafter, 172.0 g of alumina powder (average particle diameter: 10 μm) was added to the liquid A, and these components were blended so as to be uniformly dispersed, to give a mixture. The resulting mixture was used as a liquid A.

[Preparation of liquid B]

A liquid B was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 4.2 g of a trimellitic acid ester-based plasticizer, 0.20 g of benzoyl peroxide [manufactured by NOF CORPORATION, product name: NYPER BW] as a peroxide-based polymerization, and 0.15 g of pentaerythritol tetrakis(3-mercaptobutylate) as a polyfunctional thiol compound at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Example 19

[Preparation of a liquid A]

A liquid A was prepared by mixing 4.0 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 6.0 g of a trimellitic acid ester-based plasticizer, 0.39 g of N,N-bis(2-hydroxyethyl)-p-toluidine as a reaction accelerator, 10.0 g of 2-ethylhexyl acrylate, and a mixture of 0.06 g of triacryl isocyanurate and 0.24 g of triallyl isocyanurate and 0.040 g of 4-hydroxy-2,2,6,6-tetramethylpiperidine-1-oxyl as a crosslinking agent at room temperature (about 25 °C) in the air so as to be uniformly dispersed. Thereafter, 172.0 g of alumina powder (average particle diameter: 10 $\mu$m) was added to the liquid A, and these components were blended so as to be uniformly dispersed, to give a mixture. The resulting mixture was used as a liquid A.

[Preparation of liquid B]

A liquid B was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 4.2 g of a trimellitic acid ester-based plasticizer, 0.42 g of benzoyl peroxide [manufactured by NOF CORPORATION, product name: NYPER NS] as a peroxide-based polymerization, and 0.10 g of pentaerythritol tetrakis(3-mercaptobutylate) as a polyfunctional thiol compound at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

Comparative example 1

[Preparation of a liquid A]

A liquid A was prepared by mixing 2.8 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 7.1 g of a trimellitic acid ester-based plasticizer, and 10.1 g of 2-ethylhexyl acrylate at room temperature (about 25 °C) in the air so as to be uniformly dispersed. Thereafter, 172.0 g of alumina powder (average particle diameter: 10 $\mu$m) was added to the liquid A, and these components were blended so as to be uniformly dispersed, to give a mixture. The resulting mixture was used as a liquid A.

[Preparation of liquid B]

A liquid B was prepared by mixing 2.2 g of a 2-ethylhexyl acrylate/2-hydroxyethyl acrylate copolymer [2-ethylhexyl acrylate/2-hydroxyethyl acrylate (mass ratio) = 97/3, weight average molecular weight: 250000, glass transition temperature: about -69 °C] as a (meth)acrylic polymer, 5.4 g of a trimellitic acid ester-based plasticizer, and 0.21 g of benzoyl peroxide [manufactured by NOF CORPORATION, product name: NYPER NS] as a peroxide-based polymerization at room temperature (about 25 °C) in the air so as to be uniformly dispersed.

Next, a two-component-type resin composition for a heat-radiating material having the liquid A and the liquid B obtained in the above was prepared, and as the physical properties of two-component-type resin composition for a heat-radiating material, pot life, curability, thermal conductivity and moldability were examined in the same manner as in Example 1. Furthermore, bending property of a heat-radiating material obtained from the two-component-type resin composition for a heat-radiating material was examined in the same manner as in Example 3. The results are shown in Table 2.

The two-component-type resin composition for a heat-radiating material obtained above was used, and bending property of a heat-radiating material sheet obtained from the two-component-type resin composition for a heat-radiating material was tried to examine in the same manner as in Example 3. As a result, since the two-component-type resin composition for a heat-radiating material was liquid, cured product sheet could not be obtained.

[Table 2]

| Example No. | Physical properties of two-component-type resin composition for a heat-radiating material | | | | | |
|---|---|---|---|---|---|---|
| | Pot life | Curability | Thermal conductivity | Moldability | Bending property of cured product | |
| | | | | | Covered area | Exposed area |
| Example 3 | ◎ | ○ | ◎ | ◎ | ◎ | ◎ |
| Example 4 | ◎ | ○ | ◎ | ◎ | ◎ | ○ |
| Example 5 | ◎ | ◎ | ◎ | ◎ | ◎ | ○ |
| Example 6 | ◎ | ○ | ◎ | ◎ | ◎ | ○ |
| Example 7 | ◎ | ◎ | ◎ | ◎ | ◎ | □ |
| Example 8 | ◎ | ◎ | ◎ | ◎ | ◎ | □ |
| Example 9 | ◎ | ◎ | ◎ | ◎ | ◎ | □ |
| Example 10 | ◎ | ◎ | ◎ | ◎ | ◎ | ○ |
| Example 11 | ◎ | ○ | ◎ | ◎ | ◎ | ○ |
| Example 12 | ◎ | ○ | ◎ | ◎ | ◎ | ◎ |
| Example 13 | ◎ | ◎ | ◎ | ◎ | ◎ | ○ |
| Example 14 | ◎ | ○ | ◎ | ◎ | ◎ | ◎ |
| Example 15 | ◎ | ○ | ◎ | ◎ | ◎ | ○ |
| Example 16 | ◎ | ○ | ◎ | ◎ | ◎ | ◎ |
| Example 17 | ◎ | ◎ | ◎ | ◎ | ◎ | ◎ |
| Example 18 | ◎ | ○ | ◎ | ◎ | ◎ | ○ |
| Example 19 | ◎ | ○ | ◎ | ◎ | ◎ | ○ |
| Comp. Ex. 1 | ◎ | × | ※ | × | ※ | ※ |
| (Note) ※: Physical property could not be determined. | | | | | | |

From the results shown in Table 2, according to each of the working examples, it can be seen that a resin composition for a heat-radiating material having a long pot life, and being excellent in curability, thermal conductivity and moldability is obtained, and that a heat-radiating material sheet obtained from the resin composition for a heat-radiating material has a high mechanical strength. In addition, when the (meth)acrylate-based crosslinking agent is used together with the allyl group-containing crosslinking agent in a predetermined ratio in preparing the resin composition for a heat-radiating material, it can be seen that flexibility of the heat-radiating material after cured is enhanced, and that followability of the heat-radiating material to a heat-generating body and a heat-radiating body is improved.

INDUSTRIAL APPLICABILITY

The two-component-type resin composition for a heat-radiating material according to the present invention is useful, for example, for uses such as a material for releasing heat generated from a heating element such as an electric component or an electronic component used in a battery of an automobile by intervening the heat-radiating material between the heating element and a heat radiator such as a heat sink, a heat radiation fin, a resin film or a metal plate.

**Claims**

1. A two-component-type resin composition for a heat-radiating material comprising a liquid A and a liquid B, wherein the liquid A comprises a (meth)acrylic polymer, a radically polymerizable monomer, a reaction accelerator, at least one crosslinking agent selected from the group consisting of a (meth)acrylate-based crosslinking agent and an allyl group-containing crosslinking agent, and a thermally conductive material, and the liquid B comprises a (meth)acrylic polymer and a peroxide-based polymerization initiator,

   wherein the (meth)acrylic polymer of liquid A and/or liquid B is prepared by polymerizing a (meth)acrylic monomer, and the (meth)acrylic monomer includes an alkyl (meth)acrylate and a hydroxyl-group containing (meth)acrylate, and
   wherein the content of the hydroxyl-group containing (meth)acrylate in the (meth)acrylic monomer for use in the (meth)acrylic polymer is 0.3% to 30% by mass.

2. The two-component-type resin composition for a heat-radiating material according to claim 1, wherein the liquid A further comprises a plasticizer.

3. The two-component-type resin composition for a heat-radiating material according to claim 1 or 2, wherein the liquid B further comprises a plasticizer.

4. The two-component-type resin composition for a heat-radiating material according to claim 1, wherein the content of the alkyl (meth)acrylate in the (meth)acrylic monomer for use in the (meth)acrylic polymer is 50% by mass or more, and the upper limit of the content of the alkyl (meth)acrylate in the (meth)acrylic monomer for use in the (meth)acrylic polymer is 100 % by mass.

5. The two-component-type resin composition for a heat-radiating material according to any one of claims 1 to 4, wherein the total amount of the (meth)acrylic polymer used in the liquid A and the liquid B per 100 parts by mass of the radically polymerizable monomer used in the liquid A is 30 to 90 parts by mass.

6. The two-component-type resin composition for a heat-radiating material according to any one of claims 1 to 5, wherein the amount of the reaction accelerator per 100 parts by mass of the radical polymerizable monomer is 0.01 to 10 parts by mass.

7. The two-component-type resin composition for a heat-radiating material according to any one of claims 1 to 6, wherein the (meth)acrylate-based crosslinking agent is used together with the allyl group-containing crosslinking agent, and a mass ratio of the allyl group-containing crosslinking agent to the (meth)acrylate-based crosslinking agent [allyl group-containing crosslinking agent/(meth)acrylate-based crosslinking agent] is 1.5/1 to 5/1.

8. The two-component-type resin composition for a heat-radiating material according to any one of claims 1 to 7, wherein the amount of the crosslinking agent per 100 parts by mass of the radically polymerizable monomer is 0.001 to 10 parts by mass.

9. The two-component-type resin composition for a heat-radiating material according to any one of claims 2 to 8, wherein the amount of the plasticizer per 100 parts by mass of the total amount of the (meth)acrylic polymers used in the liquid A and the liquid B is 50 to 700 parts by mass.

10. The two-component-type resin composition for a heat-radiating material according to any one of claims 1 to 9, wherein the liquid A comprises a thermally conductive material, and wherein the amount of the thermally conductive material per 100 parts by mass of the total amount of the (meth)acrylic polymer and the radically polymerizable monomer is 400 to 1800 parts by mass.

**11.** The two-component-type resin composition for a heat-radiating material according to any one of claims 1 to 10, wherein the mass ratio of the reaction accelerator to the peroxide-based polymerization initiator (reaction accelerator/peroxide-based polymerization initiator) is 30/70 to 90/10.

**Patentansprüche**

**1.** Harzzusammensetzung vom Zwei-Komponenten-Typ für ein wärmeabstrahlendes Material, umfassend:

eine Flüssigkeit A und eine Flüssigkeit B, wobei die Flüssigkeit A ein (Meth)acryl-Polymer, ein radikalisch polymerisierbares Monomer, einen Reaktionsbeschleuniger, mindestens ein Vernetzungsmittel, das aus der Gruppe ausgewählt ist, die aus einem auf (Meth)acrylat basierenden Vernetzungsmittel und einem Allylgruppen enthaltenden Vernetzungsmittel besteht, sowie ein wärmeleitendes Material umfasst, und die Flüssigkeit B ein (Meth)acryl-Polymer und einen auf Peroxid basierenden Polymerisationsstarter umfasst,
wobei das (Meth)acryl-Polymer von Flüssigkeit A und/oder Flüssigkeit B durch Polymerisieren eines (Meth)acryl-Monomers hergestellt ist und das (Meth)acryl-Monomer ein Alkyl-(meth)acrylat und ein Hydroxylgruppen enthaltendes (Meth)acrylat umfasst, und
wobei der Gehalt des Hydroxylgruppen enthaltenden (Meth)acrylats in dem (Meth)acryl-Monomer zur Verwendung bei dem (Meth)acryl-Polymer 0,3 Massen-% bis 30 Massen-% beträgt.

**2.** Harzzusammensetzung vom Zwei-Komponenten-Typ für ein wärmeabstrahlendes Material gemäß Anspruch 1, wobei die Flüssigkeit A des Weiteren einen Weichmacher umfasst.

**3.** Harzzusammensetzung vom Zwei-Komponenten-Typ für ein wärmeabstrahlendes Material gemäß Anspruch 1 oder Anspruch 2, wobei die Flüssigkeit B des Weiteren einen Weichmacher umfasst.

**4.** Harzzusammensetzung vom Zwei-Komponenten-Typ für ein wärmeabstrahlendes Material gemäß Anspruch 1, wobei der Gehalt des Alkyl(meth)acrylats in dem (Meth)acrylMonomer zur Verwendung bei dem (Meth)acryl-Polymer 50 Massen-% oder mehr beträgt und die Obergrenze des Gehalts des Alkyl(meth)acrylats in dem (Meth)acryl-Monomer zur Verwendung bei dem (Meth)acryl-Polymer 100 Massen-% beträgt.

**5.** Harzzusammensetzung vom Zwei-Komponenten-Typ für ein wärmeabstrahlendes Material gemäß einem der Ansprüche 1 bis 4, wobei die Gesamtmenge des in der Flüssigkeit A und in der Flüssigkeit B verwendeten (Meth)acryl-Polymers pro 100 Massenteile des in der Flüssigkeit A verwendeten radikalisch polymerisierbaren Monomers 30 bis 90 Massenteile beträgt.

**6.** Harzzusammensetzung vom Zwei-Komponenten-Typ für ein wärmeabstrahlendes Material gemäß einem der Ansprüche 1 bis 5, wobei die Menge des Reaktionsbeschleunigers pro 100 Massenteile des radikalisch polymerisierbaren Monomers 0,01 bis 10 Massenteile beträgt.

**7.** Harzzusammensetzung vom Zwei-Komponenten-Typ für ein wärmeabstrahlendes Material gemäß einem der Ansprüche 1 bis 6, wobei das auf (Meth)acrylat basierende Vernetzungsmittel zusammen mit dem Allylgruppen enthaltenden Vernetzungsmittel verwendet wird, und ein Massenverhältnis des Allylgruppen enthaltenden Vernetzungsmittels zu dem auf (Meth)acrylat basierenden Vernetzungsmittel [Allylgruppen enthaltendes Vernetzungsmittel / auf (Meth)acrylat basierendes Vernetzungsmittel] 1,5/1 bis 5/1 beträgt.

**8.** Harzzusammensetzung vom Zwei-Komponenten-Typ für ein wärmeabstrahlendes Material gemäß einem der Ansprüche 1 bis 7, wobei die Menge des Vernetzungsmittels pro 100 Massenteile des radikalisch polymerisierbaren Monomers 0,001 bis 10 Massenteile beträgt.

**9.** Harzzusammensetzung vom Zwei-Komponenten-Typ für ein wärmeabstrahlendes Material gemäß einem der Ansprüche 2 bis 8, wobei die Menge des Weichmachers pro 100 Massenteile der Gesamtmenge des in der Flüssigkeit A und in der Flüssigkeit B verwendeten (Meth)acryl-Polymers 50 bis 700 Massenteile beträgt.

**10.** Harzzusammensetzung vom Zwei-Komponenten-Typ für ein wärmeabstrahlendes Material gemäß einem der Ansprüche 1 bis 9, wobei die Flüssigkeit A ein wärmeleitendes Material umfasst und wobei die Menge des wärmeleitenden Materials pro 100 Massenteile der Gesamtmenge des (Meth)acryl-Polymers und des radikalisch polymerisierbaren Monomers 400 bis 1800 Massenteile beträgt.

**11.** Harzzusammensetzung vom Zwei-Komponenten-Typ für ein wärmeabstrahlendes Material gemäß einem der Ansprüche 1 bis 10, wobei das Massenverhältnis des Reaktionsbeschleunigers zu dem auf Peroxid basierenden Polymerisationsstarter [Reaktionsbeschleuniger / auf Peroxid basierender Polymerisationsstarter] 30/70 bis 90/10 beträgt.

**Revendications**

**1.** Composition de résine de type bicomposant pour matériau thermo-rayonnant comprenant un liquide A et un liquide B, dans laquelle le liquide A comprend un polymère (méth)acrylique, un monomère polymérisable par voie radicalaire, un accélérateur de réaction, au moins un agent de réticulation choisi dans le groupe constitué par un agent de réticulation à base de (méth)acrylate et un agent de réticulation contenant un groupe allyle, et un matériau thermoconducteur, et le liquide B comprend un polymère (méth)acrylique et un initiateur de polymérisation à base de peroxyde,

dans laquelle le polymère (méth)acrylique du liquide A et/ou du liquide B est préparé par polymérisation d'un monomère (méth)acrylique, et le monomère (méth)acrylique comprend un (méth)acrylate d'alkyle et un (méth) acrylate contenant un groupe hydroxyle, et

dans laquelle la teneur en (méth)acrylate contenant un groupe hydroxyle dans le monomère (méth)acrylique pour une utilisation dans le polymère (méth)acrylique est de 0,3 % à 30 % en masse.

**2.** Composition de résine de type bicomposant pour matériau thermo-rayonnant selon la revendication 1, dans laquelle le liquide A comprend en outre un plastifiant.

**3.** Composition de résine de type bicomposant pour matériau thermo-rayonnant selon la revendication 1 ou 2, dans laquelle le liquide B comprend en outre un plastifiant.

**4.** Composition de résine de type bicomposant pour matériau thermo-rayonnant selon la revendication 1, dans laquelle la teneur en (méth)acrylate d'alkyle dans le monomère (méth)acrylique pour une utilisation dans le polymère (méth) acrylique est de 50 % en masse ou plus, et la limite supérieure du (méth)acrylate d'alkyle dans le monomère (méth) acrylique pour une utilisation dans le polymère (méth)acrylique est de 100 % en masse.

**5.** Composition de résine de type bicomposant pour matériau thermo-rayonnant selon l'une quelconque des revendications 1 à 4, dans laquelle la quantité totale du polymère (méth)acrylique utilisé dans le liquide A et le liquide B pour 100 parties en masse du monomère polymérisable par voie radicalaire utilisé dans le liquide A est de 30 à 90 parties en masse.

**6.** Composition de résine de type bicomposant pour matériau thermo-rayonnant selon l'une quelconque des revendications 1 à 5, dans laquelle la quantité de l'accélérateur de réaction pour 100 parties en masse du monomère polymérisable par voie radicalaire est de 0,01 à 10 parties en masse.

**7.** Composition de résine de type bicomposant pour matériau thermo-rayonnant selon l'une quelconque des revendications 1 à 6, dans laquelle l'agent de réticulation à base de (méth)acrylate est utilisé conjointement avec l'agent de réticulation contenant un groupe allyle, et un rapport massique de l'agent de réticulation contenant un groupe allyle à l'agent de réticulation à base de (méth)acrylate [agent de réticulation contenant un groupe allyle/agent de réticulation à base de (méth)acrylate] est de 1,5/l à 5/l.

**8.** Composition de résine de type bicomposant pour matériau thermo-rayonnant selon l'une quelconque des revendications 1 à 7, dans laquelle la quantité de l'agent de réticulation pour 100 parties en masse du monomère polymérisable par voie radicalaire est de 0,001 à 10 parties en masse.

**9.** Composition de résine de type bicomposant pour matériau thermo-rayonnant selon l'une quelconque des revendications 2 à 8, dans laquelle la quantité du plastifiant pour 100 parties en masse de la quantité totale des polymères (méth)acryliques utilisés dans le liquide A et le liquide B est de 50 à 700 parties en masse.

**10.** Composition de résine de type bicomposant pour matériau thermo-rayonnant selon l'une quelconque des revendications 1 à 9, dans laquelle le liquide A comprend un matériau thermoconducteur, et dans laquelle la quantité du matériau thermoconducteur pour 100 parties en masse de la quantité totale du polymère (méth)acrylique et du monomère polymérisable par voie radicalaire est de 400 à 1800 parties en masse.

11. Composition de résine de type bicomposant pour matériau thermo-rayonnant selon l'une quelconque des revendications 1 à 10, dans laquelle le rapport massique de l'accélérateur de réaction à l'initiateur de polymérisation à base de peroxyde (accélérateur de réaction/initiateur de polymérisation à base de peroxyde) est de 30/70 à 90/10.

**EP 4 023 716 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2007142528 A1
- JP 2005048124 A